# EUROPEAN PATENT SPECIFICATION

(11) **EP 0 452 054 B1**
(45) Date of publication and mention of the grant of the patent: **12.07.1995**
(21) Application number: 91303050.8
(22) Date of filing: 08.04.1991
(51) Int. Cl.: H01L 29/812, H01L 29/205, H01L 23/29

(54) **HEMT structure with passivated structure**
HEMT-Struktur mit passivierter Struktur
Structure HEMT à structure passivée

(30) Priority: 11.04.1990 US 507945
(43) Date of publication of application: 16.10.1991
(73) Proprietor: Hughes Aircraft Company, Los Angeles, California 90045-0066 (US)
(72) Inventor: Nguyen, Loi D., Agoura Hills, California 91301 (US); Delaney, Michael J., Thousand Oaks, California 91360 (US); Larson, Lawrence E., Santa Monica, California 90403 (US); Mishra, Umesh K., Cary, North Carolina 27511 (US)
(74) Representative: Colgan, Stephen James

(56) References cited:
- US-A- 4 914 488
- IEEE TRANSACTIONS ON ELECTRON DEVICES, vol. ED-33, no. 5, May 1986, pp. 601-607 ; H. HIDA et al. : "A new low-noise AlGaAs/GaAs 2DEG FET with a surface undoped layer"
- I.E.E.E. ELECTRON DEVICE LETTERS, vol. 9, no. 9, September 1988, pp. 482-484 ; U.K. MISHRA et al. : "Ultra-high-speed digital circuit performance in 0.2-mum gate-length A1InAs/GaInAs HEMT technology"

## Description

### BACKGROUND OF THE INVENTION

### Field of the Invention

The present invention generally relates to the art of electronic transistors, and more specifically to a high electron mobility field-effect transistor structure having a passivated donor layer.

### Description of the Related Art

A modulation-doped field-effect transistor (MODFET), otherwise known as a high electron mobility field-effect transistor (HEMT), is an extremely fast three-terminal electronic transistor device which has broad applications in millimeter wave systems, satellite receivers and transmitters, as well as advanced radar and fiber-optic systems. However, problems including device passivation have affected the reliability of HEMTs to such an adverse extent that widespread practical implementation has not been heretofore possible.

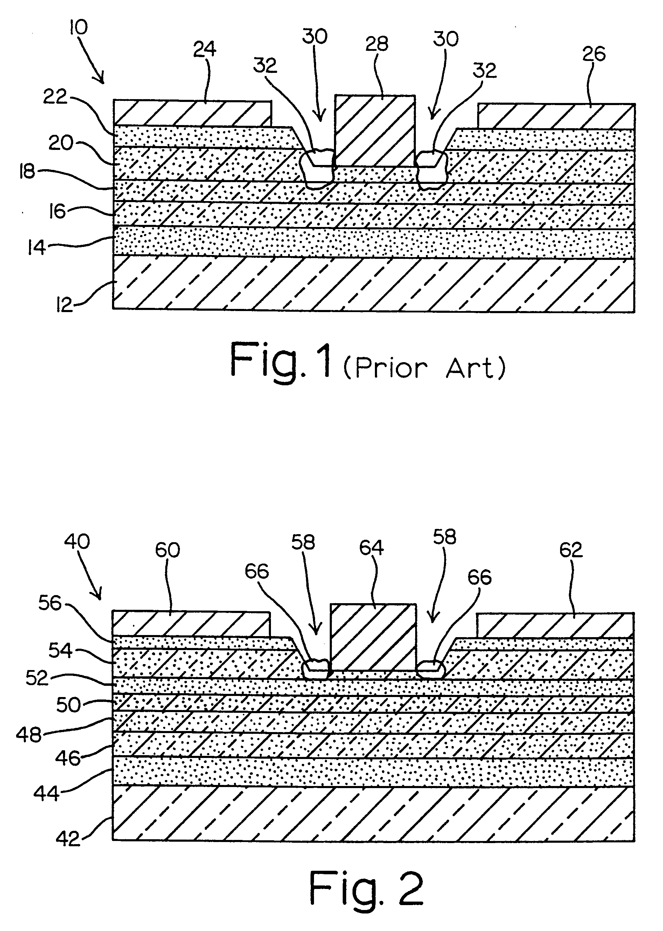

A conventional HEMT structure 10 illustrated in FIG. 1 includes a substrate 12, channel layer 14, spacer layer 16, donor layer 18, Schottky layer 20, and cap layer 22 formed on the substrate 12. A source 24 and drain 26 are formed on the cap layer 22. A grate 28 is forced on the bottom of a recess 30 which extends through the cap layer 22 and at least partially through the Schottky layer 20. The spacer, donor and Schottky layers 16, 18, 20 respectively are typically formed of a "wide" bandgap semiconductive material such as aluminum indium arsenide (AlInAs) or aluminum gallium arsenide (AlGaAs). The channel and cap layers 14 and 22 respectively are formed of a "narrow" bandgap material which is lattice-matched to the wide bandgap material, such as gallium arsenide (GaAs) or gallium indium arsenide (GaInAs). A major problem with the conventional structure is that the wide bandgap material which forms the donor and Schottky layers includes a component (aluminum in the above exemplary materials) which is prone to oxidation at low temperatures. The reference numeral 32 designates areas in which the Schottky layer 20 is exposed to the atmosphere and oxidized thereby. The oxidation spreads through the Schottky layer 20 into the donor layer 18, causing substantial reduction of the channel current.

Oxidation can be prevented by forming a passivation layer of dielectric silicon nitride or silicon oxide over the entire surface of the device, as described in an article entitled "A New GaAs Technology for Stable FET's at 300°C, by K. Fricke et al, in IEEE Electron Device Letters, vol. 10, no. 12, pp. 577-579 (Dec. 1989). The passivation layer hermetically seals the structure, preventing oxidation of the Schottky and donor layers. However, this compromises the performance of the device because of the extra capacitance created by the dielectric passivation layer. In addition, such passivation layers must be deposited at relatively high temperatures, which can degrade the performance of the device.

Hikaru Hida *et al*, in IEEE Transactions on Electron Devices, vol. ED-33, pages 601-607 (1986) describe a high-performance two-dimensional electron gas FET with a surface undoped layer. The device comprises a substrate, an undoped GaAs layer on the substrate, and a plurality of doped and undoped AlGaAs layers having graded composition on top of the GaAs layer. Between the AlGaAs layers and the source/gate/drain contacts there is provided an undoped layer of GaAs. This surface GaAs layer is employed to minimise the influence of DX centers to make ohmic contact formation easy and to suppress the surface oxidation.

US-A-4914488 describes a compound semiconductor structure, such as a heterojunction FET, in the form of a superlattice film with effectively graded average composition, comprising an alternating lamination of two kinds of layers of different composition to form pairs of layers, the ratio of the thickness of one layer to the thickness of the other in said pairs of layers being gradually varied in the direction of thickness throughout successive pairs, whereby the average composition is effectively graded throughout the pairs. In the heterojunction FET, a heavily doped GaAs cap layer is provided to form low resistance contacts with the source and drain electrodes. The gate electrode may be deposited in a recess extending through the cap layer. A layer of undoped GaAs may be deposited between the active layers and the source, gate and drain contacts.

The present invention provides a field-effect transistor structure including a substrate; a channel layer formed of a narrow bandgap semiconductor material over said substrate; a donor layer formed of an oxidizable wide bandgap semiconductive material over said channel layer to form a heterojunction therewith; and a source, drain, and gate formed over said donor layer; and at least one homogeneous oxidation-stop layer formed of a non-oxidizable narrow bandgap semiconductive material under said source, drain, and gate and sealingly extending over said donor layer, characterized in that said structure further comprises: a first Schottky layer formed of said wide bandgap semiconductive material between said source, drain, and gate and said stop layer, wherein said first Schottky layer is formed with a recess extending partially therethrough; said gate being formed on a bottom of said recess.

The invention eliminates the necessity of forming a passivation layer over the entire surface of the device, and the requisite high temperature processing steps.

In a transistor structure embodying the present invention, a donor layer, Schottky layer, and cap layer are formed on a substrate. A source and drain are formed on the cap layer. A gate is formed at the bottom of a recess which is formed through the cap layer and partially extends into the Schottky layer. The donor and Schottky layers are formed of a semiconductive material which includes an oxidizable component such as aluminum. A passivation or stop layer of a lattice-matched, non-oxidizable material is formed underlying the source, drain, and gate, and sealingly overlying the donor layer. The stop layer may be formed between the Schottky layer and the donor layer, or constitute a superlattice in combination with the Schottky layer consisting of alternating stop and Schottky sublayers.

These and other features and advantages of the present invention will be apparent to those skilled in the art from the following detailed description, taken together with the accompanying drawings, in which like reference numerals refer to like parts.
FIG. 1 is a simplified sectional view of a conventional HEMT structure, illustrating oxidation of Schottky and donor layers thereof;
FIG. 2 is a simplified sectional view of a first embodiment of a passivated transistor structure embodying the present invention;
FIG. 3 is similar to FIG. 2 but illustrates a second embodiment of the invention;
FIG. 4 is an enlarged sectional view illustrating a superlattice layer structure of the embodiment of FIG. 3.

Referring now to FIG. 2 of the drawing, a HEMT structure embodying the present invention is generally designated as 40, and includes a substrate 42 formed of a suitable material such as GaAs, GaInAs, or InP, which may have a buffer layer (not shown) of, for example, AlInAs formed thereon. A channel layer 44, spacer layer 46, donor layer 48, Schottky layer 50, passivation or stop layer 52, Schottky layer 54, and cap layer 56 are formed on the substrate 42 such that each successive layer overlies the previous layers. A recess 58 is formed through the cap layer 56, and extends at least partially into the Schottky layer 54. A source 60 and drain 62 are formed on the cap layer 56 on opposite sides of the recess 58. A gate 64 is formed on the botton of the recess 58.

The HEMT 40 operates in a conventional manner, with electrons propagating through the channel layer 44 between the source 60 and drain 62 in response to a voltage applied thereacross. The magnitude of electron flow is determined by a voltage applied to the gate 64. The donor layer 48 and channel layer 44 form a neterojunction structure, with mobile electrons from the donor layer 48 being induced into the channel layer 44 due to a space charge effect between the layers 48 and 44 (which extends across the spacer layer 46). The absence of donor atoms in the channel layer 44 greatly increases the mobility of electrons therein. The Schottky layer 54 is provided to reduce the gate leakage current of the device.

The spacer layer 46, donor layer 48, and Schottky layers 50 and 54 are formed of a wide bandgap semiconductive material such as AlInAs or AlGaAs which includes an oxidizable component, in this case aluminum. The channel layer 44 and cap layer 56 are formed of a narrow bandgap material which does not include an oxidizable component, such as GaInAs or GaAs, and is lattice-matched to the wide bandgap material. In accordance with the present invention, the passivation or stop layer 52 is formed of a lattice-matched or pseudomorphic material, preferably the same narrow bandgap material which constitutes the channel and cap layers 44 and 56 respectively, and does not include an oxidizable component.

As indicated at 66 in FIG. 2, portions of the Schottky layer 54 on opposite sides of the gate 64 in the recess 58 are exposed to the atmosphere and may oxidize. However, the oxidation is prevented from spreading to the donor layer 48 by the overlying stop layer 52, which is formed of a non-oxidizable material. The addition of the stop layer 52 reduces the Schottky barrier height of the device to a small extent, but this is not a significant problem if the stop layer 52 is made sufficiently thin.

The embodiment of FIG. 2 is particularly advantageous for forming discrete devices in GaInAs in which the spacing between the gate 64 and channel layer 44 is the same for all devices on a wafer, and is determined by a common etching process step.

Typical values for the thicknesses of the component layers of the structure 40 are as follows. However, these values are exemplary, and not to be construed as limiting the scope of the invention.

Channel layer 44 - 40 nm (400 angstroms); spacer layer 46 - 1.5 nm (15 angstroms); donor layer 48 (doped with silicon) - 5.0 - 8.0 nm (50 to 80 angstroms); Schottky layer 50 - 2.0 - 4.0 nm (20 to 40 angstroms); stop layer 52 - as thin as possible, typically 0.5 - 1.5 nm (5 to 15 angstroms); Schottky layer 54 - 15 - 20 nm (150 to 200 angstroms); cap layer 56 - 5.0 - 7.5 nm (50 to 75 angstroms). The thickness of the Schottky layer 54 in the recess 58 under the gate 64 may be approximately 2.0 - 6.0 nm (20 to 60 angstroms).

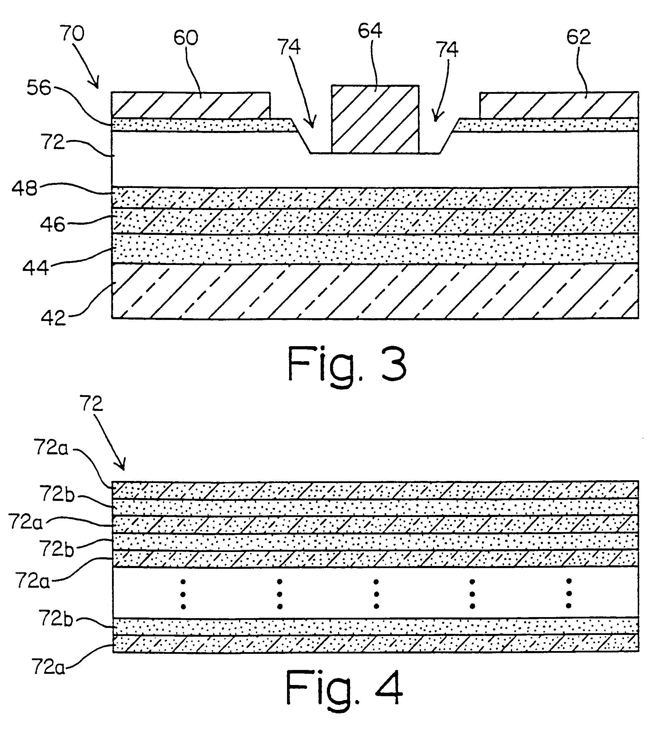

FIGs. 3 and 4 illustrate another embodiment of the present invention, in which like elements are designated by the same reference numerals used in FIG. 2. In a transistor structure 70, the layers 50, 52, and 54 are replaced by a superlattice 72 which is shown to an enlarged scale in FIG. 4. More specifically, the superlattice 72 is formed of alternating Schottky and stop sublayers 72a and 72b respectively, the numbers of which are selected in accordance with the particular application. The superlattice 72 is equivalent to the Schottky layers 48 and 54 and the stop layer 52 of FIG. 2 taken in combination. A recess 74 may be etched into the superlattice 72 to a depth which provides the desired gate to channel spacing and Schottky barrier height. Although edges of the Schottky sublayers 72a which are exposed by etching of the recess 74 are subject to oxidation, the etching is controlled to such an extent that at least one stop sublayer 72b is left unetched to sealingly overlie the donor layer 48.

Typically, the thickness of the superlattice 72 will be 20 to 25 nm (200 to 250 angstroms). The Schottky sublayers 72a will be on the order of 3 nm (30 angstroms) thick, with the stop sublayers 72b will being 1 nm (10 angstroms) thick. The superlattice period (number of alternating sublayers) will be 5 to 6.

The embodiment of FIGs. 3 and 4 is advantageous in that it enables adjustment of the gate to channel spacing on an individual device basis. It also reduces the need for precise control over the gate region etch, in applications where such precision is a particularly undesirable requirement. In the embodiment of FIG. 2, the etching must be stopped before it reaches the stop layer 52. If it did not, the oxidation could proceed through the underlying Schottky layer 50 (if provided) and donor layer 48. The embodiment of FIGs. 3 and 4 allows greater latitude in etching, since a slight over or underetch will still provide at least one stop sublayer 72b under the gate 64. The embodiment of FIGs. 3 and 4 is particularly suitable for forming dissimilar devices, having different gate to channel spacings, in a material such as AlGaAs, which has a higher Schottky barrier height and lower gate leakage current than GaInAs.

While several illustrative embodiments of the invention have been shown and described, numerous variations and alternate embodiments will occur to those skilled in the art, without departing from the scope of the invention as defined by the appended claims.

## Claims

1. A field-effect transistor structure (40,70) including a substrate (42); a channel layer (44) formed of a narrow bandgap semiconductor material over said substrate; a donor layer (48) formed of an oxidizable wide bandgap semiconductive material over said channel layer (44) to form a heterojunction therewith; and a source (60), drain (62), and gate (64) formed over said donor layer (48); and at least one homogeneous oxidation-stop layer (52,72b) formed of a non-oxidizable narrow bandgap semiconductive material under said source (60), drain (62), and gate (64) and sealingly extending over said donor layer, characterized in that said structure further comprises:
a first Schottky layer (54,72a) formed of said wide bandgap semiconductive material between said source, drain, and gate and said stop layer, wherein
said first Schottky layer is formed with a recess (58,74) extending partially therethrough;
said gate (64) being formed on the bottom of said recess (58,74).

2. A structure according to claim 1, further comprising a cap layer (56) formed of said narrow bandgap semiconductive material between said source (60) and drain (62) and said first Schottky layer (54,72a) laterally external of said recess (58,74).

3. A structure according to claim 1 or 2, further comprising a second Schottky layer (50) formed of said wide bandgap semiconductive material between said stop layer (52) and said donor layer (48).

4. A structure according to any of claims 1, 2 or 3, in which said wide bandgap semiconductive material as AlInAs, and said narrow bandgap semiconductive material is GaInAs.

5. A structure according to any of claims 1, 2 or 3, in which said wide bandgap semiconductive material is AlGaAs, and said narrow bandgap semiconductive material is GaInAs.

## Patentansprüche

1. Eine Feldeffekttransistor-Struktur (40, 70), die umfaßt: ein Substrat (42); eine über dem Substrat aus einem Halbleitermaterial mit einer schmalen Bandlücke gebildete Kanalschicht (44); eine über der Kanalschicht (44) aus einem oxidierbaren halbleitenden Material mit einer breiten Bandlücke gebildete Donatorenschicht (48), um damit einen Heteroübergang auszubilden; und eine Source (60), einen Drain (62), und ein Gate (64), ausgebildet über der Donatorenschicht (48); und wenigstens eine homogene Oxidations-Stopschicht (52, 72b), die unter der Source (60), dem Drain (62) und dem Gate (64) aus einem nicht-oxidierbaren halbleitenden Material mit einer schmalen Bandlücke gebildet ist und sich versiegelnd über die Donatorenschicht erstreckt; dadurch gekennzeichnet, daß die Struktur desweiteren umfaßt:
eine aus dem halbleitenden Material mit der breiten Bandlücke zwischen der Source, dem Drain, dem Gate und der Stopschicht ausgebildete erste Schottky-Schicht (54, 72a), worin
die erste Schottky-Schicht mit einer sich teilweise hindurch erstreckenden Aussparung (58, 74) ausgebildet ist;
das Gate (64) auf dem Boden der Aussparung (58, 74) ausgebildet wird.

2. Eine Struktur nach Anspruch 1, die desweiteren eine lateral außerhalb der Aussparung (58, 74) befindliche Deckschicht (56) umfaßt, die aus dem halbleitenden Material mit der schmalen Bandlücke zwischen der Source (60) und dem Drain (62) und der ersten Schottky-Schicht (54, 72a) ausgebildet ist.

3. Eine Struktur nach Anspruch 1 oder 2, die desweiteren eine zweite Schottky-Schicht (50) umfaßt, die aus dem halbleitenden Material mit der breiten Bandlücke zwischen der Stopschicht (52) und der Donatorenschicht (48) ausgebildet ist.

4. Eine Struktur nach einem der Ansprüche 1, 2 oder 3, in der das halbleitende Material mit der breiten Bandlücke AlInAS und das halbleitende Material mit der schmalen Bandlücke GaInAs ist.

5. Eine Struktur nach einem der Ansprüche 1, 2 oder 3, in der das halbleitende Material mit der breiten Bandlücke AlGaAS und das halbleitende Material mit der schmalen Bandlücke GaInAs ist.

## Revendications

1. Structure (40, 70) de transistor à effet de champ comportant un substrat (42); une couche (44) de canal constituée d'un matériau semiconducteur à bande interdite étroite sur ledit substrat; une couche (48) donneuse constituée d'un matériau semiconducteur oxydable à bande large interdite sur ladite couche (44) de canal pour former avec celle-ci une hétérojonction; et une source (60), un drain (62), et une grille (64) formés sur ladite couche (48) donneuse; et au moins une couche (52, 72b) homogène d'arrêt de l'oxydation constituée d'un matériau semiconducteur non oxydable à bande interdite étroite sous ladite source (60), ledit drain (62) et ladite grille (64) et s'étendant de façon scellée au-dessus de ladite couche donneuse, caractérisée en ce que ladite structure comprend en outre:
une première couche (54, 72a) à effet Schottky constituée dudit matériau semiconducteur à bande interdite large entre ladite source, ledit drain et ladite grille, et ladite couche d'arrêt,
ladite première couche à effet Schottky étant munie d'un évidement (58, 74) la traversant partiellement;
ladite grille (64) étant formée au fond dudit évidement (58, 74).

2. Structure selon la revendication 1, comprenant en outre une couche de revêtement (56) constituée dudit matériau semiconducteur à bande interdite étroite entre ladite source (60) et ledit drain (62), et ladite première couche (54, 72a) à effet Schottky étant située latéralement à l'extérieur dudit évidement (58, 74).

3. Structure selon la revendication 1 ou 2, comprenant en outre une seconde couche (50) à effet Schottky constituée dudit matériau semiconducteur à bande interdite large entre ladite couche (52) d'arrêt et ladite couche (48) donneuse.

4. Structure selon l'une quelconque des revendications 1, 2 ou 3, dans laquelle ledit matériau semiconducteur à bande interdite large est l'AlInAs, et ledit matériau semiconducteur à bande interdite étroite est le GaInAs.

5. Structure selon l'une quelconque des revendications 1, 2 et 3, dans laquelle ledit matériau semiconducteur à bande interdite large est l'AlGaAs, et ledit matériau semiconducteur à bande interdite étroite est le GaInAs.
